# EUROPEAN PATENT APPLICATION

(11) **EP 4 773 496 A1**
(43) Date of publication of application: **08.07.2026**
(21) Application number: 24866796.6
(22) Date of filing: 20.03.2024
(51) Int. Cl.: H02M 7/00, H05K 7/20

(54) **INVERTER AND PHOTOVOLTAIC SYSTEM**

(30) Priority: 19.09.2023 CN 202322555024 U
(71) Applicant: Sungrow Power Supply Co., Ltd., Hefei, Anhui 230088 (CN)
(72) Inventor: SU, Wenjie, Hefei, Anhui 230088 (CN); ZHANG, Fan, Hefei, Anhui 230088 (CN); WANG, Rui, Hefei, Anhui 230088 (CN); LIU, Yongjin, Hefei, Anhui 230088 (CN)
(74) Representative: DREISS Patentanwälte PartG mbB
(86) International application number: PCT/CN2024/082746
(87) International publication number: WO 2025/060369

(57) **Abstract**

Provided are an inverter and a photovoltaic system, which belong to the technical field of electrical equipment. The inverter includes: a housing defining a receiving cavity for mounting an electronic device, in which a lower surface of the housing includes a first region and a second region, the first region being configured for gripping, and the housing having a wiring port; a heat dissipation fin mounted at the second region; and a wiring terminal electrically connected to the wiring port of the housing. A rated power of the inverter is less than or equal to 5 kW.

## Description

### CROSS-REFERENCE TO RELATED APPLICATION

This application is based upon and claims priority to Chinese Patent Applications No. 202322555024.0, filed on September 19, 2023, the entire contents of which are incorporated herein by reference.

### FIELD

The present disclosure belongs to the technical field of electrical equipment, and more particularly, relates to an inverter and a photovoltaic system.

### BACKGROUND

An inverter is commonly used in a domestic photovoltaic system. Despite its compact size, the inverter is relatively heavy. During mounting of the inverter, an installer needs to grip the inverter to mount and fix it in place. As the inverter generates substantial heat during operation, almost all inverters available on the market incorporate heat dissipation fins. However, these heat dissipation fins often cause scratches to the installer's hands during the mounting of the inverter, posing potential safety hazards to the installer.

In the prior art, safety risks associated with the heat dissipation fins are addressed by improving the shape and structure of the heat dissipation fins. For example, in Chinese Patent Application No. CN218276497U, a plurality of heat dissipation fins are fixed at a housing of the inverter, and corners of both ends of each heat dissipation fin are in an arc shape to prevent scratches caused by the corners of the heat dissipation fins to the installer. Nevertheless, this solution only mitigates harm caused by the corners of the heat dissipation fins to the installers, while harm caused by a thin-sheet structure of the heat dissipation fins to the installer remains unresolved.

### SUMMARY

The present disclosure aims to solve at least one of the technical problems existing in the prior art. To this end, the present disclosure provides an inverter and a photovoltaic system, which can facilitate gripping of the inverter by an installer without being in contact with a heat dissipation fin. In this way, it is possible to avoid a scratch caused by a sharp part of the heat dissipation fin to the installer when force is applied with one hand on the heat dissipation fin, improving safety of the installer during operation.

**In** a first aspect, the present disclosure provides an inverter. The inverter includes: a housing defining a receiving cavity for mounting an electronic device, in which a lower surface of the housing includes a first region and a second region, the first region being configured for gripping, and the housing having a wiring port; a heat dissipation fin mounted at the second region; and a wiring terminal electrically connected to the wiring port of the housing. A rated power of the inverter is less than or equal to 5 kW.

According to the inverter provided in the embodiments of the present disclosure, by arranging the first region for gripping and the second region for mounting the heat dissipation fin, the gripping of the inverter by the installer can be facilitated without being in contact with the heat dissipation fin. In this way, it is possible to avoid the scratch caused by the sharp part of the heat dissipation fin to the installer when the force is applied with one hand on the heat dissipation fin, improving the safety of the installer during operation.

According to an embodiment of the present disclosure, the first region is located at a side of the second region in a length direction of the housing; and/or the first region is located at an outer periphery of the second region.

According to an embodiment of the present disclosure, the lower surface of the housing has a plurality of protrusions protruding outward with respect to the lower surface of the housing. The plurality of protrusions defines an air guide opening facing an air duct of the heat dissipation fin.

According to an embodiment of the present disclosure, a side of each of the plurality of protrusions adjacent to the air guide opening is provided with an arc-shaped segment, a center of curvature of the arc-shaped segment being oriented toward a lower side of the housing; and/or a height of the protrusion is greater than a height of the heat dissipation fin.

According to an embodiment of the present disclosure, the plurality of protrusions are disposed in the first region.

According to an embodiment of the present disclosure, each of the plurality of protrusions is disposed at a bottom of a corner of the housing; and/or a protrusion protruding from the lower surface is disposed between adjacent protrusions among the plurality of protrusions; and/or a protrusion protruding from the lower surface is disposed between adjacent protrusions among the plurality of protrusions. A field effect transistor of the inverter is mounted at a position corresponding to the protrusion.

According to an embodiment of the present disclosure, the heat dissipation fin includes a plurality of heat dissipation fins arranged at intervals in a first direction. A first air flow channel is formed between the plurality of heat dissipation fins arranged at intervals. A projection of a first end surface of each of the plurality of heat dissipation fins on a first plane is in a wavy shape. A normal line of the first plane is in the first direction. The first end surface is a surface of the heat dissipation fin facing away from the second region, and a second air flow channel is defined by the first end surfaces of the plurality of heat dissipation fins.

According to an embodiment of the present disclosure, wave troughs of projections of the first end surfaces of at least part of the heat dissipation fins on the first plane are staggered in a second direction, to form the second air flow channel by first end surfaces of adjacent heat dissipation fins among the plurality of heat dissipation fins.

According to an embodiment of the present disclosure, the projections of the first end surfaces of the plurality of heat dissipation fins on the first plane have a same waveform; and/or wave crests of first end surfaces of the plurality of heat dissipation fins arranged sequentially in the first direction are staggered in a same direction along the second direction; and/or wave crests of first end surfaces of any two adjacent heat dissipation fins among the plurality of heat dissipation fins in the first direction are staggered by an equal distance in the second direction; and/or the second direction is perpendicular to the first direction.

According to an embodiment of the present disclosure, a field effect transistor in the inverter is mounted at a position corresponding to the second region. A thickness of a region corresponding to the field effect transistor in a wall surface of the housing facing the heat dissipation fin is greater than thicknesses of other regions; and/or the wall surface of the housing facing the heat dissipation fin is arranged in a shape-fitting manner with respect to a height of the electronic device at an inner side of the wall surface.

According to an embodiment of the present disclosure, at least part of the heat dissipation fins have ends that extend to different positions along their a length direction of the heat dissipation fin, to form a concave-convex structure for gripping between a plurality of adjacent heat dissipation fins among the heat dissipation fins; and/or an outer side surface of a heat dissipation fin located at an end in the first direction forms a concave-convex structure for gripping.

According to an embodiment of the present disclosure, the housing is provided with a handle disposed at a position adjacent to an upper surface of the housing.

According to an embodiment of the present disclosure, the housing includes: a cover; and a box body defining the receiving cavity. The receiving cavity is internally provided with a potting adhesive. An upper surface of the box body is connected to a lower surface of the cover through the potting adhesive, and the heat dissipation fin is mounted at a lower surface of the box body.

In a second aspect, the present disclosure provides a photovoltaic system. The photovoltaic system includes: a mounting rail; the inverter as described according to any one of the above embodiments, in which the inverter is mounted on the mounting rail; and a photovoltaic module mounted on the inverter.

According to the photovoltaic system provided in the embodiments of the present disclosure, by arranging the first region for gripping and the second region for mounting the heat dissipation fin, the gripping of the inverter by the installer can be facilitated without being in contact with the heat dissipation fin. In this way, it is possible to avoid the scratch caused by the sharp part of the heat dissipation fin to the installer when the force is applied with one hand on the heat dissipation fin, improving the safety of the installer during operation.

Additional aspects and advantages of the present disclosure will be given in part in the following description, or become apparent in part from the following description, or can be learned from practicing of the present disclosure.

### BRIEF DESCRIPTION OF THE DRAWINGS

The above and/or additional aspects and advantages of the present disclosure will become more apparent and more understandable from the following description of embodiments taken in conjunction with the accompanying drawings, in which:
FIG. 1 is a first schematic structural view of an inverter according to an embodiment of the present disclosure.
FIG. 2 is an exploded view of an inverter according to an embodiment of the present disclosure.
FIG. 3 is a first bottom view of a photovoltaic system according to an embodiment of the present disclosure.
FIG. 4 is a front view of a photovoltaic system according to an embodiment of the present disclosure.
FIG. 5 is a side view of a photovoltaic system according to an embodiment of the present disclosure.
FIG. 6 is a second schematic structural view of an inverter according to an embodiment of the present disclosure.
FIG. 7 is a third schematic structural view of an inverter according to an embodiment of the present disclosure.
FIG. 8 is a fourth schematic structural view of an inverter according to an embodiment of the present disclosure.
FIG. 9 is a second bottom view of a photovoltaic system according to an embodiment of the present disclosure.

### Reference numerals:

housing 100, cover 110, box body 120, heat dissipation fin 121, first end surface 1211, rounded corner 1212, protrusion 122, first region 123, second region 124, arc-shaped segment 125, air guide opening 126, wiring port 130, mounting frame 140, potting adhesive 150, handle 160, protruding strip 170;
wiring terminal 200, mounting rail 300, photovoltaic module 400, roof 500.

### DETAILED DESCRIPTION

Embodiments of the present disclosure will be described in detail below with reference to examples thereof as shown in the accompanying drawings, throughout which same or similar elements, or elements having same or similar functions, are denoted by same or similar reference numerals. The embodiments described below with reference to the drawings are illustrative only, and are intended to explain rather than limit the present disclosure.

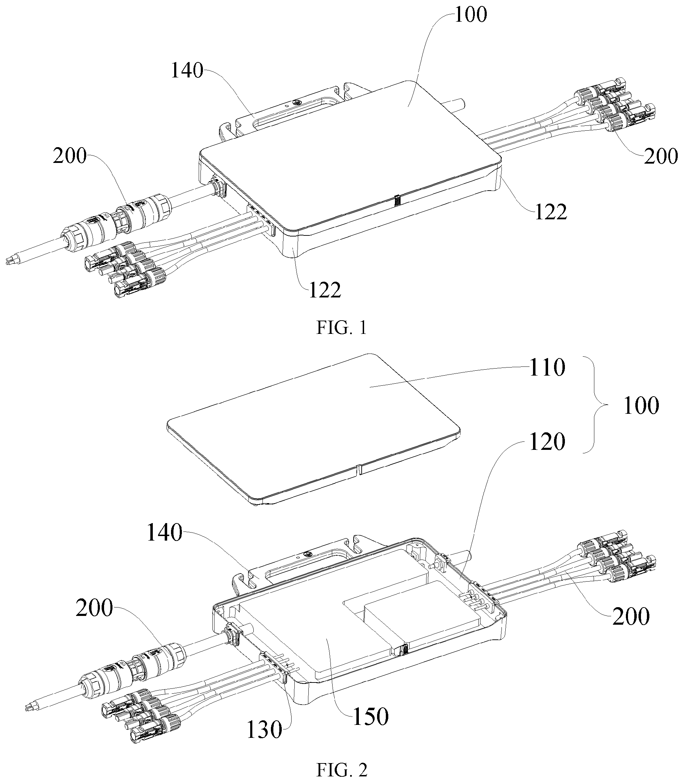

An inverter and a photovoltaic system according to the embodiments of the present disclosure are described below with reference to FIG. 1 to FIG. 5.

The embodiments of the present disclosure provide an inverter. As shown in FIG. 1 to FIG. 5, the inverter includes a housing 100, a heat dissipation fin 121, and a wiring terminal 200.

As shown in FIG. 1 to FIG. 5, the inverter is a micro-inverter with power less than or equal to 5 kW. The micro-inverter is commonly used in a domestic photovoltaic system or other small-scale photovoltaic systems. Given that an available mounting space of the house is more limited compared to that for a conventional photovoltaic system, by setting the power of the micro-inverter to be less than or equal to 5 kW, an overall size of the micro-inverter can be reduced, making it suitable for a photovoltaic system with a relatively small mounting space.

As shown in FIG. 1 to FIG. 5, the housing 100 may be of a rectangular structure, an elliptical structure, or structures in other shapes. For example, the housing 100 is of a rectangular structure with rounded corners at its four corners, to prevent the corners of the housing 100 from being too sharp to cause injuries to an installer, thus improving safety for the installer.

As shown in FIG. 2, the housing 100 defines a receiving cavity configured to mount an electronic device. The receiving cavity may also be of a rectangular structure, an elliptical structure, or structures in other shapes. For example, the receiving cavity is of a rectangular structure to match the shape and structure of the housing 100, with the electronic device mounted inside the receiving cavity.

As shown in FIG. 2, the housing 100 has a wiring port 130. The housing 100 may have wiring ports 130 disposed at two side surfaces of the housing 100 in its length direction, or at a side surface of the housing 100 in its width direction, or at other positions. The wiring terminal 200 is electrically connected to one of the wiring ports 130 of the housing 100. An end of the wiring terminal 200 is electrically connected to one of the wiring ports 130 of the housing 100, and the other end of the wiring terminal 200 is electrically connected to another electrical equipment.

As shown in FIG. 1 to FIG. 5, the number of wiring ports 130 may be greater than or equal to the number of wiring terminals 200. For example, the number of wiring ports 130 is equal to the number of wiring terminals 200, with both the wiring ports 130 and the wiring terminals 200 being three in quantity. The three wiring ports 130 are electrically connected to the three wiring terminals 200 in a one-to-one correspondence.

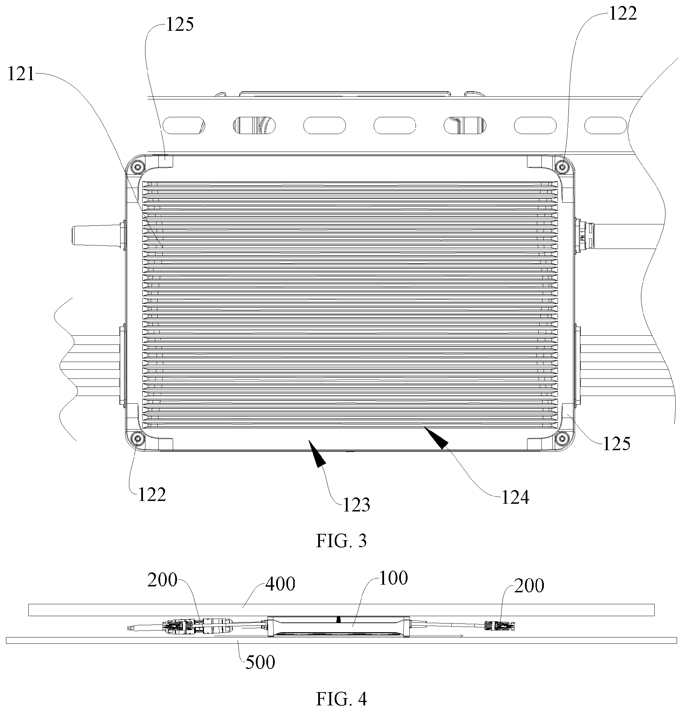

As shown in FIG. 3, a lower surface of the housing 100 includes a first region 123 and a second region 124. The first region 123 is configured to grip. A sum of an area of the first region 123 and an area of the second region 124 equals a total area of the lower surface of the housing 100. A vacant space is reserved in the first region 123 on the lower surface of the housing 100, enabling the installer to directly grip the lower surface of the housing 100 by hand.

As shown in FIG. 3, the heat dissipation fin 121 is mounted at the second region 124 and extends in the length direction of the housing 100. The heat dissipation fin 121 may be of a rectangular structure, a wave-shaped structure, or structures in other shapes. For example, the heat dissipation fin 121 is of a rectangular structure. Lengths of the heat dissipation fins 121 in the length direction of the housing 100 may be the same or different. Heights of the heat dissipation fins 121 in a height direction of the housing 100 may be the same or different.

During actual installation, when the installer mounts and fixes the inverter, the installer grips the housing 100 of the inverter with one hand. Moreover, fingers of the installer located at the lower surface of the housing 100 may grip in the first region 123. After the housing 100 is gripped, the installer then mounts and fixes the housing 100 onto a roof 500 with the other hand.

By dividing the lower surface of the housing 100 into the first region 123 and the second region 124, and arranging the heat dissipation fins 121 at the second region 124, a gripping position can be provided for the installer during the mounting of the inverter, eliminating the need for the installer to be in contact with the heat dissipation fins 121 by hand. Since the housing 100 is gripped with one hand during the mounting of the inverter, and the inverter has a predetermined weight, by providing the first region 123 for gripping instead of directly gripping the heat dissipation fins 121, it is possible to prevent the installer from being scratched by sharp parts of the heat dissipation fins 121 when force is applied with one hand. Meanwhile, the first region 123 is integrally formed, which can facilitate gripping by the installer.

According to the inverter provided in the embodiments of the present disclosure, by arranging the first region 123 for gripping and the second region 124 for mounting the heat dissipation fins 121, the gripping of the inverter by the installer can be facilitated without being in contact with the heat dissipation fins 121. In this way, it is possible to avoid the scratch caused by the sharp parts of the heat dissipation fins 121 when force is applied with one hand, improving the safety of the installer during operation.

In some embodiments, the first region 123 is located at a side of the second region 124 in a length direction of the housing 100.

The first region 123 may be of a rectangular structure, an elliptical structure, or structures in other shapes. The second region 124 may also be of a rectangular structure, an elliptical structure, or structures in other shapes. For example, each of the first region 123 and the second region 124 is of a rectangular structure.

The first region 123 may be located at one side of the second region 124 in the length direction of the housing 100, or at two sides of the second region 124 in the length direction of the housing 100. For example, the first region 123 is located at the two sides of the second region 124 in the length direction of the housing 100.

The first region 123 and the second region 124 in this structural form can be obtained by extending a length of the housing 100 or shortening the lengths of the heat dissipation fins 121. For example, the first region 123 located at the two sides of the second region 124 in the length direction of the housing 100 can be obtained by shortening the lengths of the heat dissipation fins 121. It is feasible to shorten all the heat dissipation fins 121 or only a part of the heat dissipation fins 121. Shortening mounts of the heat dissipation fins 121 may be the same or different.

Since a side edge of the housing 100 in the width direction of the housing 100 is generally mounted and fixed on the roof 500, by arranging the first region 123 at the side of the second region 124 in the length direction of the housing 100, it is convenient for the installer to grip the housing 100 and then mount and fix the side edge of the housing 100 in the width direction of the housing 100 on the roof 500 without changing the gripping position. Meanwhile, this structure is simple and can reduce production costs to some extent.

In some embodiments, as shown in FIG. 3, the first region 123 is located at an outer periphery of the second region 124.

As shown in FIG. 3, the first region 123 may be of a rectangular structure, an elliptical structure, or structures in other shapes. The second region 124 may also be of a rectangular structure, an elliptical structure, or structures in other shapes. For example, the first region 123 is of a hollow rectangular structure. Moreover, the second region 124 is of a rectangular structure and located in a hollow part of the first region 123, i.e., the second region 124 is entirely surrounded by the first region 123.

By arranging the first region 123 at the outer periphery of the second region 124, the area of the first region 123 can be increased, providing a multi-directional gripping space for the installer. This design enables installers with different operating habits to grip the housing 100 stably, thereby facilitating quick mounting and fixing of the inverter.

In other embodiments, a middle portion of the heat dissipation fin 121 may be interrupted, and the first region 123 may extend from the side of the second region 124 into the second region 124. That is, the interrupted portion of the heat dissipation fin 121 also serves as the first region 123, to allow the installer's thumb to be placed in the interrupted portion of the heat dissipation fin 121 and kept extended when the installer grips the housing 100, thereby facilitating force application for gripping the inverter by the installer.

In some embodiments, as shown in FIG. 3, the lower surface of the housing 100 has one or more protrusions 122 protruding outward with respect to the lower surface of the housing 100. The plurality of protrusions 122 defines an air guide opening 126 facing an air duct of the heat dissipation fins 121.

As shown in FIG. 3, the heat dissipation fins 121 are arranged at intervals in the width direction of the housing 100. The air ducts of the heat dissipation fins 121 are formed by gaps between two adjacent heat dissipation fins 121, i.e., the air ducts extend in the length direction of the housing 100.

As shown in FIG. 3, in response to having a single protrusion 122, the protrusion 122 supports the lower surface of the housing 100, creating a predetermined distance between the lower surface of the housing 100 and the roof 500, thus forming an air guide opening 126 that is open. In response to having a plurality of protrusions 122, and at least two of the plurality of protrusions 122 being arranged at intervals in the width direction of the housing 100, the air guide opening 126 is formed by a region enclosed by the two protrusions 122 spaced apart from each other in the width direction of the housing 100, the lower surface of the housing 100, and an upper surface of the roof 500. The air ducts of at least part of the heat dissipation fins 121 are exposed at the air guide opening 126.

For example, as shown in FIG. 3, the lower surface of the housing 100 has four protrusions 122 arranged in two pairs. The two pairs of protrusions 122 are spaced apart from each other in the length direction of the housing 100. The two protrusions 122 in each pair are spaced apart from each other in the width direction of the housing 100, i.e., the four protrusions 122 form two air guide openings 126.

As shown in FIG. 3, the protrusions 122 may be of a cylindrical structure, a rectangular structure, or structures in other shapes. For example, the protrusions 122 are of a cylindrical structure.

During actual operation, when air flows in the length direction of the housing 100, the protrusions 122 divert the airflow. A portion of the air is concentrated at the air guide opening 126 and flows into the air ducts of the heat dissipation fins 121 through the air guide opening 126, thus carrying away heat from the heat dissipation fins 121 and cooling the heat dissipation fins 121.

By arranging the above protrusions 122, the air guide opening 126 can be formed facing the air ducts of the heat dissipation fins 121, so that the flowing air is concentrated at the air guide opening 126 and guided into the air ducts of the heat dissipation fins 121. In this way, heat dissipation efficiency of the heat dissipation fins 121 is improved, and their heat dissipation effect is ensured.

In some embodiments, as shown in FIG. 3, the protrusions 122 may be disposed in the first region or the second region at the lower surface of the housing 100. Preferably, in order to prevent ends of the fins from cutting the installer's fingers and avoid the protrusions 122 occupying a space of the first region and thereby reducing heat dissipation efficiency, the protrusions 122 are disposed in the first region 123.

As shown in FIG. 3, the protrusions 122 are located in the first region 123, and the heat dissipation fins 121 are located in the second region 124, i.e., the plurality of protrusions 122 are each located at the sides of the heat dissipation fins 121. At this time, the heat dissipation fins 121 themselves are uninterrupted. The heat dissipation fins 121 extend from a side of the second region 124 in the length direction of the housing 100 to another side of the second region 124 in the length direction of the housing 100, which enables the formation of the air guide opening 126 without affecting the size of the heat dissipation fins 121, ensuring the heat dissipation area of the heat dissipation fins 121 and thus ensuring their heat dissipation effect.

In some embodiments, as shown in FIG. 3, each of the plurality of protrusions 122 is disposed at a bottom of a corner of the housing 100.

As shown in FIG. 3, the four protrusions 122 may be disposed at bottoms of four corners of the housing 100, respectively. The air ducts formed by the heat dissipation fins 121 may all be located within the air guide openings 126 formed by two adjacent protrusions 122. In this way, the flowing air converged by the air guide openings 126 can be allowed to pass through most of the air ducts of the heat dissipation fins 121, further improving the heat dissipation efficiency and effect of the heat dissipation fins 121.

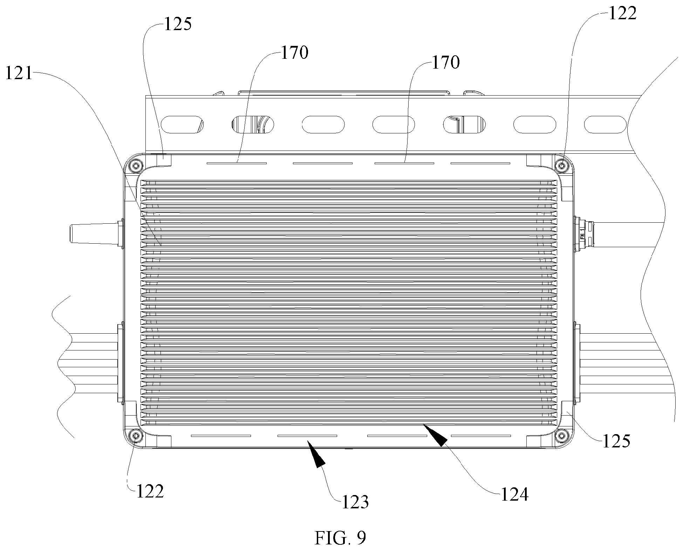

In some embodiments, as shown in FIG. 9, the protrusions 122 are disposed at corners of the lower surface of the housing 100, and a protruding strip 170 that protrudes from the lower surface is disposed between adjacent protrusions 122 among the plurality of protrusions 122.

The protruding strip 170 is provided between the protrusions 122 that are spaced apart in a first direction X. One or more protruding strips 170 may be provided. For example, as shown in FIG. 9, a plurality of protruding strips 170 are provided and arranged at intervals in the first direction X. The protruding strip 170 may also be provided between the protrusions 122 that are spaced apart in a second direction Y.

By arranging the above protruding strips 170, roughness of the first region 123 can be increased, thereby improving a friction force when the installer grips the first region 123 by hand and thereby improving stability during gripping.

In some embodiments, a protruding strip 170 that protrudes from the lower surface is disposed between adjacent protrusions 122 among the plurality of protrusions 122. A field effect transistor of the inverter is mounted at a position corresponding to the protruding strip 170. The protruding strip 170 is disposed in the first region 123 and located between the protrusions 122 spaced apart in the first direction X and the protrusions 122 spaced apart in the second direction Y.

Since the protruding strip 170 protrudes from the lower surface of the housing 100, a thickness of a part of the housing 100 where the protruding strip 170 is located is greater than the thicknesses of other parts of the housing 100. Mounting the field effect transistor at the position corresponding to the protruding strip 170 can increase heat transferred through a wall surface of the housing 100, further improving a heat dissipation effect for the field effect transistor.

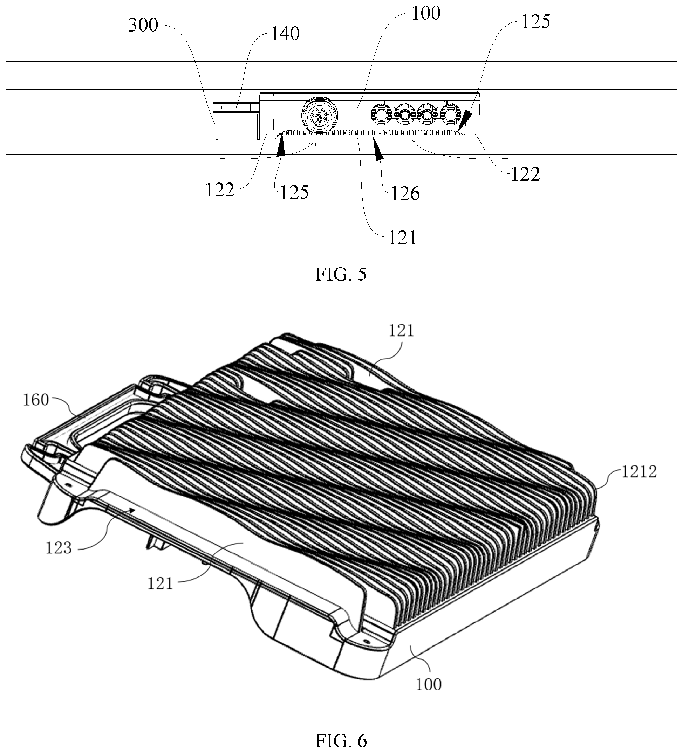

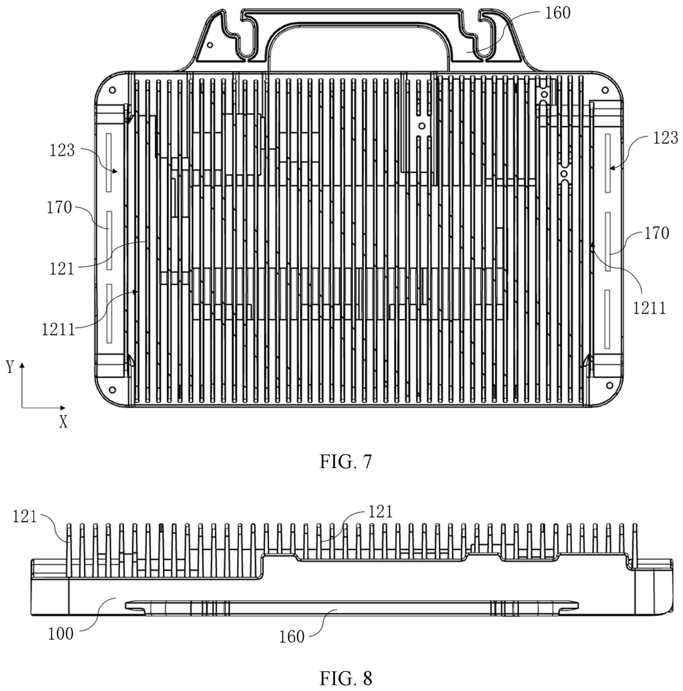

In some embodiments, as shown in FIG. 6 and FIG. 7, the heat dissipation fin 121 includes a plurality of heat dissipation fins 121 arranged at intervals in a first direction X. A first air flow channel is formed between the plurality of heat dissipation fins 121 arranged at intervals. A projection of a first end surface 1211 of each of the plurality of heat dissipation fins 121 on a first plane is in a wavy shape. A normal line of the first plane is in the first direction X. The first end surface 1211 is a surface of the heat dissipation fin 121 facing away from the second region 124, and a second air flow channel is defined by the first end surfaces 1211 of the plurality of heat dissipation fins 121.

The first direction X may be the length direction or the width direction of the housing 100. For example, as shown in FIG. 7, the first direction X is the length direction of the housing 100, i.e., the plurality of heat dissipation fins 121 are distributed in parallel and at intervals in the length direction of the housing 100.

As shown in FIG. 6 and FIG. 7, an end surface of the heat dissipation fin 121 not connected to the housing 100 is the first end surface 1211 of the heat dissipation fin 121, and the projection of the first end surface 1211 of the heat dissipation fin 121 on the first plane is a wave-shaped line.

The projection of the first end surface 1211 of the heat dissipation fin 121 on the first plane may be a regular wave-shaped line, such as a sine wave, a sawtooth wave, a square wave, a trapezoidal wave, or other types of waveforms. The projection of the first end surface 1211 of the heat dissipation fin 121 on the first plane may also be an irregular wave-shaped line.

The plurality of heat dissipation fins 121 arranged at intervals may be arranged in parallel in the first direction, or a predetermined angle may be formed between two adjacent heat dissipation fins 121.

The first air flow channel is formed between the heat dissipation fins 121, and the second air flow channel is defined by the first end surfaces 1211 of the plurality of heat dissipation fins 121. Since a side of the first air flow channel facing away from the lower surface of the housing 100 is open, the second air flow channel defined by the first end surfaces 1211 may communicate with the first air flow channel at the side facing away from the lower surface of the housing 100, with a predetermined angle between the first air flow channel and the second air flow channel.

During actual operation, as shown in FIG. 6 and FIG. 7, when the inverter dissipates heat, the air flows in the first air flow channel formed between two adjacent heat dissipation fins 121. Since a direction of the air flowing through the heat dissipation fins 121 during the heat dissipation is not fixed, and a predetermined angle occurs between the first air flow channel and the second air flow channel, when the air flows through the heat dissipation fins 121 in a direction intersecting with an extending direction of the first air flow channel, a part of the air can flow through the heat dissipation fins 121 along the second air flow channel, and carry away the air in the first air flow channel that has absorbed heat from the electronic device when passing through the second air flow channel, thereby achieving heat dissipation for the electronic device.

By designing the first end surfaces 1211 of the heat dissipation fins 121 to be in a wavy shape, the second air flow channel in communication with the first air flow channel may be defined by the first end surfaces 1211. Thus, when the air flow direction intersects with the extending direction of the first air flow channel, high-temperature air in the first air flow channel can be discharged out through the second air flow channel, facilitating discharging of hot air between the heat dissipation fins 121 from a space where the heat dissipation fins 121 are located, thereby improving the heat dissipation effect of the heat dissipation fins 121.

In some embodiments, as shown in FIG. 6 and FIG. 7, the first end surfaces 1211 of the heat dissipation fins 121 have the same waveform. Moreover, wave troughs of projections of the first end surfaces 1211 of at least part of the heat dissipation fins 121 on the first plane are staggered in a second direction Y, to form the second air flow channel by first end surfaces of adjacent heat dissipation fins 121 among the plurality of heat dissipation fins 121.

As shown in FIG. 6 and FIG. 7, the first end surfaces 1211 of the heat dissipation fins 121 have the same waveform, amplitude, and frequency, thereby forming the same wavy shape on the first end surfaces 1211 of the heat dissipation fins 121.

In other embodiments, the projections of the first end surfaces 1211 of the heat dissipation fins 121 on the first plane have different waveforms, amplitudes, and frequencies.

As shown in FIG. 6 and FIG. 7, the waveforms of the projections of the first end surfaces 1211 of at least part of the heat dissipation fins 121 on the first plane have a phase difference in the second direction Y. The second direction Y is perpendicular to the first direction X. For example, the first direction X is the length direction of the housing 100, and the second direction Y is the width direction of the housing 100. Since the waveforms of the projections of the first end surfaces 1211 of the at least part of the heat dissipation fins 121 on the first plane have a phase difference in the second direction Y, when viewed from the first direction X, the heat dissipation fins 121 with phase differences have wave crests staggered in the first direction X and wave troughs staggered in the first direction X.

It can be understood that when the wave troughs of the projections of the first end surfaces 1211 of the heat dissipation fins 121 on the first plane are aligned in the second direction Y, a linear air duct extending in the first direction X may be formed between the wave crests of the plurality of heat dissipation fins 121. The air may flow in the air duct extending in the first direction X. Therefore, by setting the wave troughs of the projections of the first end surfaces 1211 of at least part of the heat dissipation fins 121 on the first plane to be staggered in the second direction Y, an at least partially curved air duct extending in the first direction X can be formed between the wave troughs of the plurality of heat dissipation fins 121, which thus can prolong a time length of the air flowing in the air duct extending in the first direction X and further improve the heat dissipation effect and capacity of the heat dissipation fins 121.

In some embodiments, as shown in FIG. 6 and FIG. 7, wave crests of first end surfaces 1211 of the plurality of heat dissipation fins 121 arranged sequentially in the first direction X are successively staggered in the same direction along the second direction Y. Wave crests of first end surfaces 1211 of any two adjacent heat dissipation fins 121 among the plurality of adjacent heat dissipation fins 121 in the first direction X are staggered by an equal distance in the second direction Y. The second direction Y is perpendicular to the first direction X.

As shown in FIG. 6 and FIG. 7, a phase difference occurs between two adjacent heat dissipation fins 121, and the direction and distance where the two adjacent heat dissipation fins 121 are staggered are the same. For example, a second heat dissipation fin 121 is staggered relative to a first heat dissipation fin 121 by one-eighth of a wavelength in the second direction Y. A third heat dissipation fin 121 is staggered relative to the second heat dissipation fin 121 by one-eighth of the wavelength in the same direction along the second direction Y. The rest can be done in the same manner.

With the above arrangement of the heat dissipation fins 121, a linear air duct is formed between the first end surfaces 1211 of the plurality of heat dissipation fins 121. Moreover, an angle is formed between an extending direction of the air duct and the first direction X, i.e., the air duct is inclined with respect to the first direction X. In this way, resistance of the first end surfaces 1211 of the heat dissipation fins 121 to the air can be reduced, while prolonging a path of the air duct and improving the heat dissipation effect.

In some embodiments, a ratio of a distance by which wave crests of first end surfaces 1211 of two adjacent heat dissipation fins 121 are staggered in the second direction Y to a spacing distance of the two adjacent heat dissipation fins 121 in the first direction X is a, which satisfies: 15°≤arctan a≤75°.

Since an air duct intersecting with the first direction X is formed by the wave-shaped arrangement of the first end surfaces 1211 of the plurality of heat dissipation fins 121, an angle between the air duct that is formed by the wave-shaped arrangement of the first end surfaces 1211 of the plurality of heat dissipation fins 121 and intersects with the first direction X and the first direction X can be derived using arctan a, where a is the ratio of the distance by which the wave crests of the first end surfaces 1211 of two adjacent heat dissipation fins 121 are staggered in the second direction Y to the spacing distance of the two adjacent heat dissipation fins 121 in the first direction X.

The value of arctan a ranges from 15° to 75°. arctan a may be particularly 15°, 25°, 30°, 45°, 60°, 75°, or another value ranging from 15° to 75°, which is not specifically limited herein.

By setting arctan a to satisfy 15°≤arctan a≤75°, it is possible to reduce a probability that an excessively small arctan a causes a relatively short path of the air duct that intersects with the first direction X and is formed by the wave-shaped arrangement of the first end surfaces 1211, resulting in a poor heat dissipation effect; meanwhile, it is also possible to reduce a probability that an excessively large arctan a causes a direction of the air duct formed by the first end surfaces 1211 to be the same as a direction of an air duct originally formed between the heat dissipation fins 121, resulting in a poor heat dissipation effect.

In some embodiments, a wavelength of each of the first end surfaces 1211 of the heat dissipation fins 121 is L, and a wave height of each of the first end surfaces 1211 of the heat dissipation fins 121 is H, where 5 mm≤L≤50 mm, and 1 mm≤H≤10 mm.

The value of L ranges from 5 mm to 50 mm. The value of L may be particularly 5 mm, 10 mm, 15 mm, 20 mm, 25 mm, 30 mm, 40 mm, 50 mm, or another value ranging from 5 mm to 50 mm, which is not specifically limited herein.

The value of H ranges from 1 mm to 10 mm. The value of H may be particularly 1 mm, 2 mm, 3 mm, 4 mm, 6 mm, 8 mm, 9 mm, 10 mm, or another value ranging from 1 mm to 10 mm, which is not specifically limited herein.

It can be understood that when the wavelength of each of the first end surfaces 1211 of the heat dissipation fins 121 is too large, the number of air ducts formed by the first end surfaces 1211 of the heat dissipation fins 121 decreases, thus reducing the heat dissipation effect. When the wavelength of each of the first end surfaces 1211 of the heat dissipation fins 121 is too small, the width of the air duct formed by the first end surfaces 1211 of the heat dissipation fins 121 is relatively narrow, making it difficult for the air to flow in the air duct and thus affecting the heat dissipation effect. Therefore, by setting the wavelength L of each of the first end surfaces 1211 of the heat dissipation fins 121 to satisfy 5 mm≤L≤50 mm, the number of air ducts formed by the first end surfaces 1211 can be increased, while expanding the width of the air ducts, facilitating flow of the air and improving the heat dissipation efficiency.

Meanwhile, when the wave height of each of the first end surfaces 1211 of the heat dissipation fins 121 is too large, the area of each of the heat dissipation fins 121 decreases, thus reducing the heat dissipation effect. When the wave height of each of the first end surfaces 1211 of the heat dissipation fins 121 is too small, a subtle waveform formed by the first end surface 1211 of the heat dissipation fin 121 is caused, i.e., a depth of the air duct formed by the first end surfaces 1211 is relatively small, making it difficult for the air to flow along the air duct. Therefore, by setting the wave height H of each of the first end surfaces 1211 of the heat dissipation fins 121 to satisfy 1 mm≤H≤10 mm, the area of the heat dissipation fin 121 can be increased, while increasing the depth of the air duct, thereby further improving the heat dissipation efficiency.

In some embodiments, as shown in FIG. 6 and FIG. 7, the first direction X is the length direction of the housing 100, or forms an acute angle with the length direction of the housing 100.

As shown in FIG. 6 and FIG. 7, when the first direction X is the length direction of the housing 100, the plurality of heat dissipation fins 121 are arranged at intervals in the length direction of the housing 100. Moreover, the wavy waveforms of the first end surfaces 1211 of the plurality of heat dissipation fins 121 form an air duct having an angle with the length direction of the housing 100.

When the first direction X forms an acute angle with the length direction of the housing 100, the plurality of heat dissipation fins 121 are arranged at intervals in the first direction X.

Moreover, the wavy waveforms of the first end surfaces 1211 of the plurality of heat dissipation fins 121 can form air ducts extending in the length direction of the housing 100, thereby prolonging a time length of the air flowing in the air ducts in different directions.

In some embodiments, as shown in FIG. 6 and FIG. 7, each of corners of the first end surfaces 1211 of the heat dissipation fins 121 in the length direction of the heat dissipation fins 121 is provided with a rounded corner 1212.

A rounded corner 1212 is formed at connections between the first end surfaces 1211 of the heat dissipation fins 121 and two side surfaces of the heat dissipation fins 121 in their own length direction.

By providing the rounded corner 1212 at the corners of the first end surfaces 1211 of the heat dissipation fins 121 in the length direction of the heat dissipation fins 121, smoothness of the heat dissipation fin 121 can be improved, a probability that the installer is scratched by edges and corners of the heat dissipation fins 121 can be reduced, and the safety of the installer during operation can be improved.

In some embodiments, as shown in FIG. 8, a first cross-section of each of the heat dissipation fins 121 is trapezoidal, with its lower base being an end connected to the second region 124. A normal line of the first cross-section is in the length direction of the heat dissipation fins 121.

As shown in FIG. 8, a cross-section obtained by cutting the heat dissipation fins 121 in their own width direction is the first cross-section, which is trapezoidal. Since a width of the lower base of the trapezoid is greater than that of its upper base, widths of lower surfaces of the heat dissipation fins 121 are greater than that of their upper surfaces. Moreover, the lower surfaces of the heat dissipation fins 121 are used to be connected to the second region 124. The lower ends of two adjacent heat dissipation fins 121 are spaced apart from each other in the first direction X.

During actual operation, when the electronic device generates heat during operation, the heat is transferred to the lower surfaces of the heat dissipation fins 121 through the wall surface of the housing 100, and then transferred from the lower surfaces of the heat dissipation fins 121 to the upper surfaces of the heat dissipation fins 121.

Since the widths of the heat dissipation fins 121 gradually decrease from the lower surfaces to the upper surfaces, by designing the first cross-sections of the heat dissipation fins 121 to be trapezoidal, heat absorbed by the lower ends of the heat dissipation fins 121 connected to the second region 124 can be increased, thereby increasing a cooling rate of the electronic device. Meanwhile, widths of upper ends of the heat dissipation fins 121 are relatively small, which can increase a width of the air duct formed between two adjacent heat dissipation fins 121, thereby increasing an air flow rate and improving the heat dissipation effect.

In some embodiments, a field effect transistor in the inverter is mounted at a position corresponding to the second region 124.

It can be understood that among various electronic devices disposed in the inverter, the field effect transistor generates a large amount of heat during operation, i.e., a region where the field effect transistor is located is a high-temperature region of the inverter. Therefore, by mounting the field effect transistor at the position corresponding to the second region 124, a contact area between the wall surface of the housing 100 corresponding to the field effect transistor and the heat dissipation fins 121 can be increased, thereby improving the heat dissipation effect of the heat dissipation fins 121 on the field effect transistor, while having little impact on the first region 123 for gripping.

In some embodiments, a thickness of a region corresponding to the field effect transistor in a wall surface of the housing 100 facing the heat dissipation fin 121 is greater than thicknesses of other regions.

The field effect transistor may be disposed in the middle of the second region 124 or at other positions of the second region 124. For example, when the field effect transistor is disposed in the middle of the second region 124, a thickness of a wall surface of the housing 100 connected to the heat dissipation fins 121 is increased at the position corresponding to the field effect transistor in the second region 124.

A surface of the region corresponding to the field effect transistor on the wall surface of the housing 100 facing the heat dissipation fin 121 may be flat or in a wave shape to improve the heat dissipation effect.

By increasing the thickness of the region corresponding to the field effect transistor in the wall surface of the housing 100 facing the heat dissipation fin 121, heat absorbed by a region of the wall surface of the housing 100 corresponding to the field effect transistor can be increased, thereby further increasing a heat dissipation speed of the field effect transistor and improving the heat dissipation efficiency.

In some embodiments, the wall surface of the housing 100 facing the heat dissipation fin 121 is arranged in a shape-fitting manner with respect to a height of the electronic device at an inner side of the wall surface.

The electronic devices in the inverter vary in type and shape, and consequently differ in their own height. In this way, a distance from each position on the wall surface of the housing 100 facing the heat dissipation fin 121 to a circuit board is equal to a height of the electronic device corresponding to the position of the wall surface. For example, when an electronic device has a relatively high height, a portion of the wall surface of the housing 100 facing the heat dissipation fin 121 that corresponds to the electronic device protrudes outward away from the electronic device. At this time, the electronic device may be mounted between the circuit board and a groove formed by the outward protrusion of the wall surface, to allow the distances between the wall surface of the housing 100 facing the heat dissipation fin 121 and each of the electronic devices to be the same.

During actual operation, the circuit board configured to mount the electronic device is mounted in the receiving cavity and located on the side of the receiving cavity facing away from the heat dissipation fin 121. The electronic device is mounted between a side of the circuit board facing the heat dissipation fin 121 and the wall surface of the housing 100 facing the heat dissipation fin 121.

In the assembled inverter, a side of the housing 100 facing away from the heat dissipation fin 121 is a flat surface. Since the height of the electronic device is smaller than a height of the heat dissipation fin 121, an outwardly protruding part of the wall surface of the housing 100 facing the heat dissipation fin 121 is unlikely to protrude upward beyond the heat dissipation fin 121. That is, from the overall perspective of the inverter, multiple protrusions of different heights are not readily visible.

By arranging the wall surface of the housing 100 facing the heat dissipation fin 121 in a shape-fitting manner with respect to the height of the electronic device at the inner side of the wall surface, overall neatness of the inverter can be improved. Meanwhile, regions of the housing 100 excluding the part of the housing 100 corresponding to the field effect transistor can have the same thickness, improving thickness uniformity of the housing 100.

In some embodiments, as shown in FIG. 6 and FIG. 7, the first region 123 includes a region located at an outer side of the heat dissipation fin 121 at the end in the first direction X. Moreover, the heat dissipation fin 121 at the end in the first direction X is spaced apart from an edge of the housing 100 in the length direction of the heat dissipation fins 121.

As shown in FIG. 6 and FIG. 7, the first region 123 on the lower surface of the housing 100 includes a region located outside two outermost heat dissipation fins 121 in the first direction X. This region is used for gripping by the installer.

Since it is generally needed to connect the inverter's side in the second direction Y to the mounting rail 300 during the mounting of the inverter, by setting the first region 123 to include the region located at the outer side of the heat dissipation fin 121 at the end in the first direction X, the installer can be facilitated in gripping the inverter when mounting the inverter to the mounting rail 300.

In some embodiments, at least part of the heat dissipation fins 121 have ends that extend to different positions along a length direction of the heat dissipation fin, so as to form, between a plurality of adjacent heat dissipation fins 121, a concave-convex structure for gripping; and/or an outer side surface of a heat dissipation fin 121 located at an end in the first direction forms a concave-convex structure for gripping.

The heat dissipation fins 121 may extend in the length direction or width direction of the housing 100.

Ends of the heat dissipation fins 121 that extend to closer positions form a recessed part of the concave-convex structure for placing the installer's fingers. Ends of the heat dissipation fins 121 that extend to farther positions form a protruding part of the concave-convex structure. The protruding part may be located between two fingers, thus integrally forming the concave-convex structure for gripping.

When the heat dissipation fins 121 extend in the width direction of the housing 100, the first direction is the length direction of the housing 100. In this way, a concave-convex structure is formed by outer side surfaces of the two outermost heat dissipation fins 121 in the length direction of the housing 100. A curved or discontinuous concave-convex structure may be formed at the outer side surfaces of the two outermost heat dissipation fins 121. A projection of the concave-convex structure on the second region may be of an S-shaped structure or of structures in other shapes.

With the above arrangement of the concave-convex structure, a position where the installer grips the inverter can be defined, reducing a probability that the installer is injured by gripping other positions. Meanwhile, lengths of some of the heat dissipation fins 121 can be lengthened to some extent, thereby further improving the heat dissipation effect and efficiency of the heat dissipation fins 121.

In some embodiments, as shown in FIG. 6 to FIG. 8, the housing 100 is provided with a handle 160.

The handle 160 may be disposed at a side surface of the housing 100 in the first direction X, or at a side surface of the housing 100 in the second direction Y, or at other positions. For example, as shown in FIG. 6 to FIG. 8, the handle 160 is disposed at the side surface of the housing 100 in the second direction Y.

The handle 160 may be disposed in the middle of the side surface of the housing 100 in the second direction Y, or at a side or other positions of the side surface of the housing 100 in the second direction Y.

With the above arrangement of the handle 160, the installer can carry the inverter by holding the handle 160 during transportation of the inverter, facilitating the transportation of the inverter and improving efficiency of transporting the inverter.

In some embodiments, as shown in FIG. 6 to FIG. 8, the handle 160 is disposed at a position adjacent to an upper surface of the housing 100.

As shown in FIG. 6 to FIG. 8, the handle 160 is disposed at a position of the side surface of the housing 100 in the second direction Y adjacent to the upper surface of the housing 100. A side surface of the handle 160 facing away from the heat dissipation fins 121 in the height direction of the housing 100 may be flush with the upper surface of the housing 100, or may be disposed with a small spacing from the upper surface of the housing 100.

During actual operation, since the upper surface of the inverter is generally flat, when it is necessary to transport the inverter to a designated location, upper surfaces of two inverters can be brought into face-to-fact contact. At this time, handles 160 of the two inverters are also mated together, and the installer's hands may pass through both the handles 160 of the two inverters and lift the two inverters.

It should be noted that during the transportation of the inverters, wave crests and wave troughs on first end surfaces 1211 of heat dissipation fins 121 of the two inverters can also be interdigitated, so that the two inverters may be combined for carrying. The interdigitation of the wave crests and wave troughs of the heat dissipation fins 121 of the two inverters can improve the stability when a plurality of inverters are stacked together.

By disposing the handle 160 at the position adjacent to the upper surface of the housing 100, a distance between the handles 160 of the two inverters can be reduced when the installer lifts both the two inverters, making it easier for the installer to grip both the handles 160 by hand.

In some embodiments, as shown in FIG. 3 and FIG. 5, a side of each of the plurality of protrusions 122 adjacent to the air guide opening 126 is provided with an arc-shaped segment 125. A center of curvature of the arc-shaped segment 125 is oriented toward a lower side of the housing 100.

As shown in FIG. 3 and FIG. 5, four protrusions 122 are located at the bottoms of the four corners of the housing 100, respectively. A side of each protrusion 122 facing the adjacent protrusion 122 is provided with an arc-shaped segment 125. The arc-shaped segment 125 may be connected to the lower surface of the protrusion 122 and the lower surface of the housing 100, or connected to the side of the protrusion 122 and the lower surface of the housing 100.

The center of curvature of the arc-shaped segment 125 is oriented toward the lower side of the housing 100. The arc-shaped segments 125 on the two protrusions 122 that form the air guide opening 126-located on the sides of the two protrusions 122 that are close to each other-are arranged oppositely. For example, as shown in FIG. 3 and FIG. 5, the arc-shaped segment 125 for the left protrusion 122 is arranged facing right, and the arc-shaped segment 125 for the right protrusion 122 is arranged facing left. At this time, an air guide opening 126, which is similar to an arch, is formed by two arc-shaped segments 125 and the lower surface of the housing 100.

With the above arrangement of the arc-shaped segments 125, an arched air guide opening 126 may be formed. In this way, a convergence effect of the air guide opening 126 is improved, and the air flow rate through the air ducts of the heat dissipation fins 121 is increased, to further improve the heat dissipation efficiency and effect of the heat dissipation fins 121.

In some embodiments, as shown in FIG. 4 and FIG. 5, heights of the protrusions 122 are greater than heights of the heat dissipation fins 121.

As shown in FIG. 4 and FIG. 5, a distance between the lower surface of the protrusion 122 and the lower surface of the housing 100 is greater than a distance between the lower surfaces of the heat dissipation fins 121 and the lower surface of the housing 100. Moreover, the heights of the protrusions 122 are smaller than a distance between a lower surface of a photovoltaic module 400 and the upper surface of the roof 500, to ensure that the inverter can be mounted between the photovoltaic module 400 and the roof 500.

As shown in FIG. 4 and FIG. 5, when the inverter is mounted on the roof 500, the lower surfaces of the protrusions 122 are supported at the upper surface of the roof 500. Since the heights of the protrusions 122 are greater than the heights of the heat dissipation fins 121, when the protrusions 122 are supported on the roof 500, a predetermined gap occurs between the lower surfaces of the heat dissipation fins 121 and the upper surface of the roof 500.

By setting the heights of the protrusions 122 to be greater than the heights of the heat dissipation fins 121, a predetermined gap may be formed between the heat dissipation fins 121 and the roof 500, and the air may flow in this gap. When the air flows in the gap, heat from the lower surfaces of the heat dissipation fins 121 can be taken away, thereby increasing the heat dissipation area of the heat dissipation fins 121 and improving the heat dissipation effect and efficiency of the heat dissipation fins 121.

In some embodiments, as shown in FIG. 2, the housing 100 includes a cover 110 and a box body 120.

As shown in FIG. 2, the box body 120 defines a receiving cavity with an opening at a top of the receiving cavity. The heat dissipation fins 121 are mounted at a lower surface of the box body 120. The lower surface of the box body 120 includes the first region 123 and the second region 124. The receiving cavity is internally provided with a potting adhesive 150. An upper surface of the box body 120 is connected to a lower surface of the cover 110 through the potting adhesive 150. The box body 120 has a wiring port 130.

During actual assembly, the electronic device is mounted in the receiving cavity of the box body 120, and the receiving cavity is covered with the cover 110, and the wiring terminal 200 is electrically connected to the wiring port 130 on the box body 120. Then, a high-temperature liquid potting adhesive 150 is poured into the receiving cavity. After the potting adhesive 150 solidifies, the cover 110 is connected to the box body 120.

With the above arrangement of the cover 110 and the box body 120, the mounting of the electronic device can be facilitated. Meanwhile, the cover 110 is connected to the box body 120 by the potting adhesive 150, which provides a firm connection and simple operation.

The embodiments of the present disclosure further provide a photovoltaic system. As shown in FIG. 3 to FIG. 5, the photovoltaic system includes a mounting rail 300, the inverter according to any of the above embodiments, and a photovoltaic module 400.

As shown in FIG. 3 to FIG. 5, the photovoltaic system may be a domestic photovoltaic system. The inverter is provided with a mounting frame 140 at a side of the inverter in its width direction. The mounting frame 140 is used to be connected to the mounting rail 300. The mounting rail 300 is mounted on the roof 500. The inverter is mounted on the mounting rail 300. The photovoltaic module 400 is mounted on the inverter.

During actual installation, when the inverter is mounted, the installer grips the first region 123 of the inverter with one hand, fixes the mounting frame 140 of the inverter to the mounting rail 300 with screws, then mounts the photovoltaic module 400 on the inverter, and covers the mounting rail 300 and the inverter with the photovoltaic module 400.

According to the photovoltaic system provided in the embodiments of the present disclosure, by arranging the first region 123 for gripping and the second region 124 for mounting the heat dissipation fins 121, the gripping of the inverter by the installer can be facilitated without being in contact with the heat dissipation fins 121. In this way, it is possible to avoid the scratch caused by the sharp parts of the heat dissipation fins 121 when the force is applied with one hand, improving the safety of the installer during operation.

Terms such as "first" and "second" in the specification and claims of the present disclosure are used only to distinguish between similar objects, rather than to describe a particular order or sequence. It should be understood that the data as used can be interchanged where appropriate, to enable the embodiments of the present disclosure described herein to be implemented in an order other than that illustrated or described herein. Also, the objects distinguished by the terms such as "first" and "second" are usually objects of the same type. The quantity of objects is not limited. For example, a first object may be one first object or plurality of first objects. In addition, "and/or" throughout the specification and claims indicates at least one of the objects associated with "and/or". The character "/" generally indicates that the associated objects before and after the character are in an "or" relationship.

In the description of the present disclosure, it should be understood that, the orientation or the position indicated by terms such as "length", "width", "thickness", "over", "below", "front", "rear", "left", "right", "top", "bottom", "inner", and "outer" should be construed to refer to the orientation and the position as shown in the drawings, and is only for the convenience of describing the present disclosure and simplifying the description, rather than indicating or implying that the pointed device or element must have a specific orientation, or be constructed and operated in a specific orientation, and therefore cannot be understood as a limitation of the present disclosure.

In the description of the present disclosure, "the first feature" and "the second feature" may include one or more of these features.

In the description of the present disclosure, "plurality" means two or more.

In the description of the present disclosure, the first feature "on" or "under" the second feature may mean that the first feature is in direct contact with the second feature, or the first and second features are in indirect contact through another feature between the first and second features.

In the description of the present disclosure, the first feature "above" the second feature means that the first feature is directly above or obliquely above the second feature, or simply means that the level of the first feature is higher than that of the second feature.

In the description of the present disclosure, description with reference to "an embodiment", "some embodiments", "an illustrative embodiment", "an example", "a specific example", "some examples", or the like means that a particular feature, structure, material, or characteristic described in connection with the embodiment or example is included in at least one embodiment or example of the present disclosure. The appearances of the above phrases in various places throughout this specification are not necessarily referring to the same embodiment or example of the present disclosure. Further, the particular features, structures, materials, or characteristics described here may be combined in any suitable manner in one or more embodiments or examples.

Although embodiments of the present disclosure have been illustrated and described, it is conceivable for those skilled in the art that various changes, modifications, replacements, and variations can be made to these embodiments without departing from the principles and spirit of the present disclosure. The scope of the present disclosure shall be defined by the claims as appended and their equivalents.

## Claims

1. An inverter, comprising:
a housing defining a receiving cavity for mounting an electronic device, wherein a lower surface of the housing comprises a first region and a second region, the first region being configured for gripping, and the housing having a wiring port;
a heat dissipation fin mounted at the second region; and
a wiring terminal electrically connected to the wiring port of the housing,
wherein a rated power of the inverter is less than or equal to 5 kW.

2. The inverter according to claim 1, wherein:
the first region is located at a side of the second region in a length direction of the housing; and/or
the first region is located at an outer periphery of the second region.

3. The inverter according to claim 1 or 2, wherein the lower surface of the housing has a plurality of protrusions protruding outward with respect to the lower surface of the housing, the plurality of protrusions defining an air guide opening facing an air duct of the heat dissipation fin.

4. The inverter according to claim 3, wherein:
a side of each of the plurality of protrusions adjacent to the air guide opening is provided with an arc-shaped segment, a center of curvature of the arc-shaped segment being oriented toward a lower side of the housing; and/or
a height of the protrusion is greater than a height of the heat dissipation fin.

5. The inverter according to claim 3 or 4, wherein the plurality of protrusions are disposed in the first region.

6. The inverter according to any one of claims 3 to 5, wherein:
each of the plurality of protrusions is disposed at a bottom of a corner of the housing; and/or
a protrusion protruding from the lower surface is disposed between adjacent protrusions among the plurality of protrusions; and/or
a protruding strip protruding from the lower surface is disposed between adjacent protrusions among the plurality of protrusions, a field effect transistor of the inverter being mounted at a position corresponding to the protruding strip.

7. The inverter according to any one of claims 1 to 6, wherein the heat dissipation fin comprises a plurality of heat dissipation fins arranged at intervals in a first direction, wherein a first air flow channel is formed between the plurality of heat dissipation fins arranged at intervals, a projection of a first end surface of each of the plurality of heat dissipation fins on a first plane being in a wavy shape, a normal line of the first plane being in the first direction, and the first end surface being a surface of the heat dissipation fin facing away from the second region, and wherein a second air flow channel is defined by the first end surfaces of the plurality of heat dissipation fins.

8. The inverter according to claim 7, wherein wave troughs of projections of the first end surfaces of at least part of the heat dissipation fins on the first plane are staggered in a second direction, to define the second air flow channel by first end surfaces of adjacent heat dissipation fins among the plurality of heat dissipation fins.

9. The inverter according to claim 7 or 8, wherein:
the projections of the first end surfaces of the plurality of heat dissipation fins on the first plane have a same waveform; and/or
wave crests of first end surfaces of the plurality of heat dissipation fins arranged sequentially in the first direction are staggered in a same direction along the second direction; and/or
wave crests of first end surfaces of any two adjacent heat dissipation fins among the plurality of heat dissipation fins in the first direction are staggered by an equal distance in the second direction; and/or
the second direction is perpendicular to the first direction.

10. The inverter according to any one of claims 1 to 9, wherein a field effect transistor in the inverter is mounted at a position corresponding to the second region, wherein:
a thickness of a region corresponding to the field effect transistor in a wall surface of the housing facing the heat dissipation fin is greater than thicknesses of other regions; and/or
the wall surface of the housing facing the heat dissipation fin is arranged in a shape-fitting manner with respect to a height of the electronic device at an inner side of the wall surface.

11. The inverter according to any one of claims 1 to 10, wherein:
at least part of the heat dissipation fins have ends that extend to different positions along a length direction of the heat dissipation fin, to form a concave-convex structure for gripping between a plurality of adjacent heat dissipation fins among the heat dissipation fins; and/or
an outer side surface of a heat dissipation fin located at an end in the first direction forms a concave-convex structure for gripping.

12. The inverter according to any one of claims 1 to 11, wherein the housing is provided with a handle disposed at a position adjacent to an upper surface of the housing.

13. The inverter according to any one of claims 1 to 12, wherein the housing comprises:
a cover; and
a box body defining the receiving cavity, the receiving cavity being internally provided with a potting adhesive, an upper surface of the box body being connected to a lower surface of the cover through the potting adhesive, and the heat dissipation fin being mounted at a lower surface of the box body.

14. A photovoltaic system, comprising:
a mounting rail;
the inverter according to any one of claims 1 to 13, wherein the inverter is mounted on the mounting rail; and
a photovoltaic module mounted on the inverter.
